Europäisches Patentamt

(19) European Patent Office

Office européen des brevets

(11) Numéro de publication : **0 461 011 A1**

(12) **DEMANDE DE BREVET EUROPEEN**

(21) Numéro de dépôt : **91401419.6**

(22) Date de dépôt : **30.05.91**

(51) Int. Cl.⁵ : **C23C 8/36,** C23C 8/38, C21D 1/09

(30) Priorité : **05.06.90 FR 9007061**

(43) Date de publication de la demande :
**11.12.91 Bulletin 91/50**

(84) Etats contractants désignés :
**AT BE CH DE DK ES FR GB GR IT LI LU NL SE**

(71) Demandeur : **UGINE ACIERS DE CHATILLON ET GUEUGNON**
**Immeuble Ile-de France, 4, Place de la Pyramide**
**F-92070 Paris La Défense Cédex 33 (FR)**

(72) Inventeur : **De Gelis, Pierre**
**4ter, rue Bonnemain**
**78104 Saint Germain en Laye (FR)**
Inventeur : **Piet, Gérard**
**1, rue Maurice Berteaux**
**95870 Bezons (FR)**
Inventeur : **Pontet, Joelle**
**6, Impasse Maréchal De Lattre de Tassigny**
**71130 Gueugnon (FR)**
Inventeur : **Pacqueau, Gérard**
**Aux Angles, Montmorte**
**71320 Toulon-sur-Arroux (FR)**

(74) Mandataire : **Martin, Jean-Paul et al**
**c/o CABINET LAVOIX 2, Place d'Estienne d'Orves**
**F-75441 Paris Cedex 09 (FR)**

(54) **Procédé de coloration d'une bande d'un matériau métallique en défilement par plasma basse température.**

(57) L'invention a pour objet un procédé de coloration d'un matériau métallique par exposition de celui-ci à un plasma basse température conduisant à la formation sur le matériau d'une mince couche d'oxydes, caractérisé en ce que on place ledit matériau à colorer, sous forme d'une bande (6) préalablement conditionnée sous forme d'une bobine (7), sur un rouleau dévideur (8), on déroule ladite bobine en contrôlant la vitesse de défilement de la bande, on fait passer ladite bande sur un support conducteur (11) auquel fait face au moins une électrode (15) dite électrode-source définissant un espace (20) entre elle et la surface de la bande, l'électrode source étant en un matériau dont on veut déposer les oxydes sur la bande et étant refroidie de manière à assurer une coloration uniforme de la bande, ledit support et ladite électrode-source étant placés à l'intérieur d'une enceinte étanche (1) dans laquelle on introduit, sous une pression contrôlée inférieure à 1000 Pa environ, une atmosphère comprenant au moins un gaz dont la molécule comporte des atomes d'oxygène, on génère un plasma basse température dans ledit espace tout en maintenant le support conducteur à un potentiel supérieur à celui de l'électrode-source, et on enroule la bande, après son passage sur le support conducteur, autour d'un rouleau récepteur (9) en la reconditionnant sous forme de bobine (10).

EP 0 461 011 A1

Fig. 1

La présente invention concerne la coloration superficielle d'une bande d'un matériau métallique en défilement, par exposition de la surface dudit matériau à un plasma basse température.

On connaît des procédés de traitement superficiel de matériaux métalliques utilisant un plasma dit "basse température" ou "froid", par opposition aux plasmas de fusion thermonucléaires appelés plasmas "chauds". Le degré d'ionisation d'un plasma basse température est faible ($10^{-7}$ à $10^{-3}$). L'énergie électrique est transférée aux électrons qui sont assez peu nombreux, mais très énergétiques (1 à 10 eV). Ils excitent ainsi le gaz à chauffer, dont la température peut aller de 20 à 700°C environ, et produisent des espèces excitées en grand nombre. Une des méthodes de production d'un tel plasma consiste à établir une décharge électroluminescente entre deux électrodes (cathode et anode) se faisant face au sein d'une atmosphère raréfiée, sous une pression inférieure à 1000 Pa. D'autres méthodes de production du plasma, telles que l'excitation de l'atmosphère raréfiée par des micro-ondes ou des radiofréquences sont également connues, et applicables au traitement superficiel des matériaux métalliques.

La demanderesse a elle-même déposé des demandes de brevet français sur des procédés de traitement superficiel de matériaux métalliques par des plasmas froids. La demande FR 8805091 concerne un procédé pour améliorer la résistance à la corrosion d'un échantillon. A cet effet, ledit échantillon est polarisé négativement et exposé à un plasma comportant, au moins à l'état de traces, un gaz oxydant dans une enceinte de pression de 1 à 1000 Pa. Dans un exemple de mise en oeuvre , la tension entre l'anode et la cathode, cette dernière étant constituée par l'échantillon lui-même, est de l'ordre de 100 à 5000 V et le temps de traitement varie de 1 s à 10 min environ.

Le procédé décrit dans la demande FR 8913879 vise à améliorer l'adhérence sur la surface d'un échantillon d'un revêtement qui serait ultérieurement appliqué sur cette surface. Comme dans le procédé précédent, l'échantillon à traiter doit être polarisé négativement.

Enfin, le procédé décrit dans la demande FR 89 08085 permet de colorer la surface d'un échantillon, tel qu'une plaque d'acier inoxydable. Celui-ci est placé dans une atmosphère raréfiée comportant un plasma oxydant. Contrairement aux deux procédés précédents, l'échantillon est polarisé positivement. Des atomes sont arrachés par le plasma à une électrode-source (cathode) placée face à l'échantillon. Ces atomes sont oxydés par le plasma, et les oxydes ainsi formés vont se déposer sur l'échantillon. Cette couche d'oxydes procure à la surface de l'échantillon une coloration due à des phénomènes d'interférences lumineuses, dont la teinte est fonction de l'épaisseur de la couche et dépend donc des conditions opératoires et de la durée de l'expérience.

Les exemples connus d'application des procédés de traitement superficiel auxquels il vient d'être fait allusion concernent tous le traitement de pièces unitaires de dimensions en général relativement faibles.

Le but de l'invention est de rendre possible l'application de ces procédés au traitement de bandes métalliques de grandes longueurs.

A cet effet, l'invention a pour objet un procédé de coloration de matériaux métalliques par exposition de celui-ci à un plasma basse température conduisant à la formation sur le matériau d'une mince couche d'oxydes, caractérisé en ce que on place ledit matériau à colorer, sous forme d'une bande préalablement conditionnée sous forme d'une bobine, sur un rouleau dévideur, on déroule ladite bobine en contrôlant la vitesse de défilement de la bande, on fait passer ladite bande sur un support conducteur auquel fait face au moins une électrode dite électrode-source définissant un espace entre elle et la surface de la bande, l'électrode-source étant en un matériau dont on veut déposer les oxydes sur la bande et étant refroidie de manière à assurer une coloration uniforme de la bande, ledit support et ladite électrode-source étant placés à l'intérieur d'une enceinte étanche dans laquelle on introduit, sous une pression contrôlée inférieure à 1000 pa environ, une atmosphère comprenant au moins un gaz dont la molécule comporte des atomes d'oxygène, on génère un plasma basse température dans ledit espace tout en maintenant le support conducteur à un potentiel supérieur à celui de l'électrode-source, et on enroule la bande, après son passage sur le support conducteur, autour d'un rouleau récepteur en la reconditionnant sous forme de bobine. Préférentiellement on refroidit également le support conducteur. Le plasma peut être généré par l'établissement d'une décharge électroluminescente entre l'électrode-source et la portion de la bande en contact avec le support conducteur, l'électrode-source étant placée en cathode et le support conducteur en anode dans le circuit de production de la décharge électroluminescente.

Comme on l'aura compris, le procédé selon l'invention vise à traiter en une fois non plus des pièces métalliques isolées, mais des bandes dont la longueur et la largeur ne sont limitées que par la taille de l'installation. Ces bandes peuvent être ultérieurement découpées pour former des tôles de la longueur désirée. Selon le nombre et la disposition des ensembles électrode-support conducteur utilisés, il est possible de traiter seulement l'une ou les deux faces de la bande.

L'invention sera mieux comprise au vu de la description suivante, faisant référence à la planche unique de dessins comprenant :

– la figure 1 schématisant une installation pour la mise en oeuvre de ce procédé vue de profil, l'enceinte la renfermant étant représentée en coupe.

– la figure 2 schématisant une variante d'exécution de cette installation.

L'installation est placée dans une enceinte étanche 1, dont la paroi 2 est munie d'une orifice 3 permettant d'introduire dans l'enceinte le gaz ou le mélange gazeux plasmagène contenu dans un récipient 21. Ce gaz ou ce mélange gazeux doit contenir au moins à l'état de traces un gaz dont la molécule renferme des atomes d'oxygène, tel que l'oxygène lui-même, l'ozone, l'air, les oxydes d'azote, la vapeur d'eau. Un autre orifice 4 permet de relier l'intérieur de l'enceinte à un dispositif d'aspiration 5 qui permet de maintenir la pression dans l'enceinte à une valeur connue et contrôlée. Cette pression doit être telle que, conjuguée aux autres paramètres opératoires de l'installation, elle permette la production dans l'enceinte par décharge électroluminescente d'un plasma froid. Pratiquement une telle pression doit de toute façon être inférieure à 1000 Pa environ, typiquement de 0,1 à 1000 Pa.

La bande 6 dont une des faces est à colorer est introduite dans l'enceinte sous forme d'une bobine 7, qui est montée sur un rouleau 8 dit rouleau dévideur pouvant tourner librement ou de manière asservie autour de son axe, de manière à permettre à la bobine de se dérouler. Au cours de son déroulement, la bande vient s'enrouler autour d'un autre rouleau 9 dit rouleau récepteur dont l'axe est parallèle à celui du rouleau dévideur 8, pour former une autre bobine 10. Grâce à un dispositif d'entraînement, tel qu'un couple de rouleaux 22, 22' en rotation asservie la bande 6 peut défiler à une vitesse linéaire connue pouvant être maintenue constante. Le dispositif d'entraînement peut également agir non directement sur la bande, mais sur le rouleau récepteur 9. Il peut aussi, dans ce dernier cas, être connecté à un autre dispositif assurant l'entraînement du rouleau dévideur 8, ces deux dispositifs coopérant pour assurer une tension sensiblement constante de la bande y compris lors des périodes pendant lesquelles on fait varier la vitesse de défilement de la bande 6. Cette vitesse est mesurée par un dispositif 23, agissant par contact avec la bande 6 ou de toute autre manière. Au cours de son trajet entre les deux bobines 7 et 10, la bande 6 passe sur un rouleau 11 électriquement conducteur muni de moyens de refroidissement internes tels qu'une circulation d'eau ou de tout autre fluide refroidissant comprenant une conduite d'amenée 12 et une conduite d'évacuation 12', et pouvant tourner autour d'un axe parallèle aux axes des rouleaux dévideur 8 et récepteur 9. La rotation du rouleau conducteur suit le défilement de la bande 6 et peut être libre, ou être asservie, grâce à des moyens d'entraînement non représentés, à la vitesse de défilement de la bande 6. Dans ce dernier cas, on peut éviter tout glissement de la bande 6 sur le rouleau 11, ce qui évite une détérioration de la surface de la bande 6 qui est en contact avec la surface externe du rouleau 11, et on améliore la régularité du défilement de la bande 6. Au moyen d'un contact électrique 13 de type quelconque compatible avec la rotation du rouleau 11, tel qu'un balai, le rouleau 11 est relié au pôle $\oplus$ d'une alimentation électrique 14.

L'installation comprend également une électrode-source 15, montée sur un support 16, reliée au pôle $\ominus$ de l'alimentation électrique 14, et qui joue donc un rôle de cathode, alors que le rouleau conducteur 11 joue un rôle d'anode. Un dispositif de régulation 24 permet de contrôler la différence de potentiel entre le support conducteur 11 et l'électrode-source 15. L'électrode 15 est refroidie intérieurement, par exemple au moyen d'une circulation d'eau ou de tout autre fluide refroidissant comprenant une conduite d'amenée 17 et une conduite d'évacuation 17'. La surface 18 de l'électrode-source 15 tournée vers la bande 6 est généralement parallèle à la portion de la surface 19 de la bande 6 qui lui fait face. Les surfaces 18 et 19 définissent ainsi un espace 20 de largeur constante "l". C'est à l'intérieur de cet espace qu'est créé par décharge électroluminescente le plasma froid qui assure le traitement de coloration de la face de la bande 6 tournée vers la surface 18 de l'électrode 15. Comme exposé dans le document FR 8908085 déjà cité, cette coloration est obtenue par le dépôt sur la surface 19 de la bande 6 d'une mince (quelques centaines d'Å) couche d'oxydes métalliques, dont les atomes métalliques ont été arrachés à la surface 18 de l'électrode-source 15. La nature de ces oxydes dépend de celle du matériau constituant l'électrode-source. Une électrode en acier inoxydable ferritique permet de former un dépôt à base d'oxydes de fer et de chrome. Une électrode en acier inoxydable austénitique permet de former un dépôt à base d'oxydes de fer, de chrome et de nickel, etc... Pour obtenir un dépôt particulièrement résistant à la corrosion, on peut employer une électrode-source en métal noble pur (titane, chrome ou aluminium par exemple) qui permet de former un dépôt ne comportant que des oxydes de ce métal. Les autres conditions opératoires nécessaires à l'exécution d'un tel traitement sont :

– différence de potentiel entre l'électrode-source 15 et l'ensemble formé par le rouleau conducteur 11 et la bande 6 : 200 à 5000 V environ ;

– densité de courant dans la bande 6 : 1 à 100 mA/cm2 .

– temps pendant lequel une portion donnée de la bande 6 se trouve face à l'électrode-source 15 : jusqu'à 60 minutes ;

– distance "l" entre la bande 6 et l'électrode-source 15; 1 mm à plusieurs centimètres, de préférence 1 à 50 mm.

Pour des conditions expérimentales données, la coloration obtenue dépend du temps de traitement, et il est aisé de déterminer expérimentalement quelle couleur correspond à quel temps de traitement, c'est-à-dire au temps pendant lequel une portion de la surface fait face à l'électrode-source. L'épaisseur de la couche d'oxydes augmente si le temps de traitement augmente, si la densité de courant dans la bande 6 augmente, si la différence de potentiel entre la bande 6 et l'électrode-source 15 augmente, si la largeur "l" de l'espace 20 diminue.

Pour éviter que le plasma ne se forme à partir de l'ensemble de la surface de l'électrode-source 15, ce qui créerait des phénomènes parasites nuisant à une bonne régularité du fonctionnement de l'appareil et provoquerait une usure exagérée de l'électrode-source, on peut gainer l'électrode-source 15 par un matériau isolant, tel que de la Sirilite®, en ne laissant découverte que la surface active 18 qui fait face à la surface 19 de la bande 6. Ce gainage (non représenté sur la figure) peut être remplacé par un anneau de garde, c'est-à-dire une électrode polarisée positivement dont la forme épouse celle des surfaces de l'électrode-source 15 autres que la surface active 18 et est placée à une faible distance d'elles, de l'ordre de 0,5 mm à quelques cm. Cette distance est déterminée de manière à rendre impossible la formation d'un plasma entre les faces en regard de ces deux électrodes compte tenu des autres conditions expérimentales. Elle est de toute façon inférieure à la distance entre la surface active 18 de l'électrode-source et la surface 19 de la bande 6.

Telle qu'elle vient d'être décrite, l'installation permet de colorer une seule des faces de la bande 6. Si on désire colorer ses deux faces, il faut alors ajouter à l'installation un deuxième ensemble rouleau conducteur/électrode-source similaire au premier et exposant la face de la bande 6 non encore colorée à un plasma qui s'établit entre elle et la deuxième électrode-source, la face déjà colorée étant mise au contact du deuxième rouleau conducteur.

Le refroidissement de l'électrode-source 15 est indispensable pour l'obtention d'une coloration uniforme de la surface de la bande 6. Le refroidissement du rouleau conducteur 11 est également utile à cet effet.

Le rouleau conducteur 11 peut être remplacé par tout support conducteur, pouvant de préférence accompagner la bande dans son défilement. Mais un tel rouleau est particulièrement avantageux par sa facilité de mise en oeuvre et par la qualité et la constance du contact avec la bande qu'il permet d'établir.

Optionnellement, le support 16 de l'électrode-source peut être déplacé de manière à faire varier la largeur "l" de l'espace 20. Cependant, si on désire maintenir une valeur identique de "l" dans tout l'espace 20, il faut qu'à chaque largeur de l'espace 20 corresponde un modèle d'électrode-source 15 dont la face active 18 possède un rayon de courbure adapté à cet effet. Si r est le rayon de courbure du rouleau conducteur 11, la face active 18 doit avoir un rayon de courbure égal à r + 1, et son centre de courbure doit être confondu avec le centre du rouleau conducteur 11. Ceci dit, une telle constance de "l" n'est pas à proprement parler indispensable au bon fonctionnement de l'appareil, en particulier à la reproductibilité et à l'homogénéité des colorations obtenues. En effet, si la configuration de la zone dans laquelle s'établit le plasma reste la même du début à la fin du défilement de la bobine qui s'effectue à vitesse constante, toutes les parties de la bobine auront subi un traitement identique, et il suffit de savoir par expérience, pour une configuration donnée de la zone des électrodes, quelles autres conditions opératoires conduisent à telle coloration pour que celle-ci soit reproductible.

On peut également prévoir des moyens de type connu et non représenté pour insérer entre les spires de la bobine 10 une feuille de papier ou de plastique dont le rôle est d'éviter la détérioration des surfaces de la bande par frottement des spires les unes sur les autres.

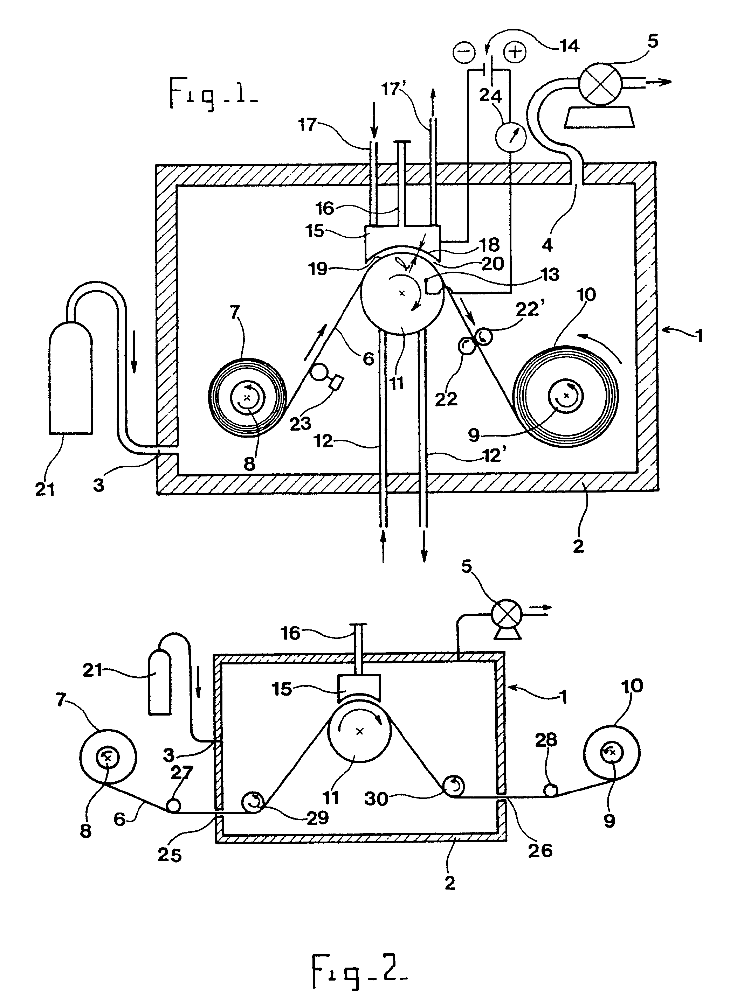

En variante d'exécution, comme schématisé sur la figure 2, on peut choisir de placer les rouleaux dévideur 8 et récepteur 9 hors de l'enceinte étanche 1. Après avoir quitté le rouleau dévideur 8, la bande 6 pénètre dans l'enceinte 1 par une ouverture 25 munie de moyens permettant d'assurer un contact étanche entre la paroi 2 et la bande 6. Une ouverture similaire 26 permet la sortie de la bande de l'enceinte 1 en direction du rouleau récepteur 9. A l'extérieur de l'enceinte 1, la bande 6 passe sur des cabestans 27, 28 qui orientent son défilement, de manière à ce que la bande 6 entre et sorte de l'enceinte selon une direction constante, indépendante des diamètres des bobines 7, 10 enroulées sur les rouleaux 8 et 9. D'autres cabestans 29, 30, placés à l'intérieur de l'enceinte, complètent le guidage de la bande 6, et garantissent notamment un arc de contact de la bande 6 sur le rouleau conducteur 11 constant. La figure 2 montre également l'électrode-source 15 et son support 16, l'alimentation en gaz 21 et l'installation de régulation de la pression dans l'enceinte 5. Les autres organes, communs avec ceux de l'installation de la figure 1, ne sont pas représentés.

Dans les configurations qui viennent d'être décrites, le matériau métallique est inclus comme anode dans le circuit électrique qui produit la décharge électroluminescente à l'origine de la formation du plasma froid. Mais cette condition n'est pas obligatoire pour obtenir la coloration de l'échantillon. L'essentiel est que l'installation comporte des moyens pour maintenir l'échantillon à un potentiel positif par rapport à celui de l'électrode-source à laquelle sont arrachés les atomes dont les oxydes se retrouvent sur l'échantillon. De la même façon, le plasma n'est pas forcément produit par décharge électroluminescente entre l'électrode-source et l'échantillon, mais peut l'être par excitation de l'atmosphère par micro-ondes ou par radiofréquence.

Les dimensions des bobines traitées ne sont limitées que par la taille de l'installation.

Le traitement de coloration superficielle s'adresse principalement aux bobines d'acier inoxydable, puisque le métal ne doit pas ensuite subir de traitement de surface (par exemple contre la corrosion) qui viendrait en masquer les effets. Toutefois il est possible de l'appliquer à tout matériau métallique conditionné sous forme de bobine, qu'il soit nu ou pourvu d'un revêtement métallique (par exemple des aciers revêtus de zinc par électrodéposition ou par galvanisation). Par matériau métallique on entend aussi bien un matériau métallique massif qu'un matériau composite dans lequel des composants métalliques et non-métalliques sont intimement mêlés, ou qu'une couche métallique solidaire de la surface d'un substrat non-métallique, comme c'est le cas dans les tôles dites "tôles sandwich".

Bien entendu, sans sortir de l'esprit de l'invention, les organes de l'installation tels qu'ils viennent d'être décrits peuvent être remplacés par leurs équivalents techniques, et des perfection- nements ne remettant pas en cause l'architecture et le fonctionnement de l'installation peuvent lui être apportés. Ainsi, on peut adjoindre à l'installation tout aménagement visant à augmenter le rendement d'ionisation dans le plasma. Un tel aménagement peut consister, de manière connue, en des moyens pour créer un champ magnétique entre l'électrode et le support conducteur, tels qu'un aimant permanent ou un électroaimant. Le champ magnétique a pour effet d'allonger le parcours des ions et des électrons, et on obtient ainsi l'augmentation recherchée du rendement d'ionisation dans le plasma. Il est ainsi possible, également, de travailler à des pressions plus faibles que 0,1 Pa.

**Revendications**

1)Procédé de coloration d'un matériau métallique par exposition de celui-ci à un plasma basse température conduisant à la formation sur le matériau d'une mince couche d'oxydes, caractérisé en ce que on place ledit matériau à colorer, sous forme d'une bande préalablement conditionnée sous forme d'une bobine, sur un rouleau dévideur, on déroule ladite bobine en contrôlant la vitesse de défilement de la bande, on fait passer ladite bande sur un support conducteur auquel fait face au moins une électrode dite électrode-source définissant un espace entre elle et la surface de la bande, l'électrode source étant en un matériau dont on veut déposer les oxydes sur la bande et étant refroidie de manière à assurer une coloration uniforme de la bande, ledit support et ladite électrode-source étant placés à l'intérieur d'une enceinte étanche dans laquelle on introduit, sous une pression contrôlée inférieure à 1000 Pa environ, une atmosphère comprenant au moins un gaz dont la molécule comporte des atomes d'oxygène, on génère un plasma basse température dans ledit espace tout en maintenant le support conducteur à un potentiel supérieur à celui de l'électrode-source, et on enroule la bande, après son passage sur le support conducteur, autour d'un rouleau récepteur en la reconditionnant sous forme de bobine.

2) Procédé selon la revendication 1, caractérisé en ce qu'on refroidit également le support conducteur de la bande.

3) Procédé selon la revendication 1 ou 2, caractérisé en ce qu'on génère le plasma par l'établissement d'une décharge électroluminescente entre l'électrode-source et la portion de la bande en contact avec le support conducteur, l'électrode-source étant placée en cathode et le support conducteur en anode dans le circuit de production de la décharge électroluminescente.

4) Procédé selon l'une des revendications 1 à 3, caractérisé en ce qu'on crée un champ magnétique entre l'électrode-source et le support conducteur.

5) Procédé selon l'une des revendications 1 à 4, caractérisé en ce que le matériau métallique à colorer est une bande d'acier inoxydable.

6) Procédé selon l'une des revendications 1 à 4, caractérisé en ce que le matériau métallique à colorer est une bande d'acier revêtue d'une couche métallique.

Fig.1

Fig.2

Office européen
des brevets

**RAPPORT DE RECHERCHE EUROPEENNE**

Numero de la demande

EP 91 40 1419

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y,P | EP-A-0 394 159 (USINOR SACILOR S.A.)<br>* Revendications 1-10 *<br>--- | 1,3,5 | C 23 C 8/36<br>C 23 C 8/38<br>C 21 D 1/09 |
| Y | PATENT ABSTRACTS OF JAPAN, vol. 11, no. 136 (C-419)[2583], 30 avril 1987; & JP-A-61 271 335 (HIRAOKA & CO., LTD) 01-12-1986<br>* Résumé en entier *<br>--- | 1,3,5 | |
| A | DE-A-1 783 088 (KALLE AG)<br>* Revendication; figure *<br>--- | 1,3 | |
| A | DE-A-3 723 865 (SANDO IRON WORKS)<br>* Revendications 1-3; figures 1,4 *<br>--- | 1,3 | |
| A | PATENT ABSTRACTS OF JAPAN, vol. 10, no. 362 (C-389)[2419], 4 décembre 1986; & JP-A-61 157 671 (SUMITOMO METAL IND., LTD) 17-07-1986<br>* Résumé en entier *<br>--- | 1 | |
| A | DE-A-2 435 446 (HOLLINGSWORTH)<br>--- | | **DOMAINES TECHNIQUES RECHERCHES (Int. Cl.5)**<br>C 23 C<br>C 21 C |
| A | EP-A-0 340 077 (IRSID)<br>----- | | |

Le présent rapport a été établi pour toutes les revendications

| Lieu de la recherche<br>LA HAYE | Date d'achèvement de la recherche<br>12-09-1991 | Examinateur<br>WITTBLAD U.A. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P0403)

8